# FASCICULE DE BREVET EUROPEEN

(11) **EP 3 305 048 B1**
(45) Date de publication et mention de la délivrance du brevet: **31.07.2019**
(21) Numéro de dépôt: 16727397.8
(22) Date de dépôt: 27.05.2016
(51) Int. Cl.: H05K 7/20

(54) **CARTE ÉLECTRONIQUE ET PROCÉDÉ DE FABRICATION ASSOCIÉ**
LEITERPLATTE UND ZUGEHÖRIGES HERSTELLUNGSVERFAHREN
ELECTRONIC BOARD AND ASSOCIATED MANUFACTURING METHOD

(30) Priorité: 29.05.2015 FR 1501114
(43) Date de publication de la demande: 11.04.2018
(73) Titulaire: Thales, 92400 Courbevoie (FR)
(72) Inventeur: PREDON, Eric, 29280 Locmaria-Plouzane (FR); BELEC, Pierre, 29217 Plougonvelin (FR)
(74) Mandataire: Derval, Estelle
(86) Numéro de dépôt international: PCT/EP2016/062048
(87) Numéro de publication internationale: WO 2016/193162

(56) Documents cités:
- EP-A1- 1 603 376
- FR-A1- 2 742 294
- FR-A1- 2 875 372
- US-A- 5 949 191
- US-A1- 2008 304 237

## Description

L'invention concerne le refroidissement de cartes électroniques enfichées dans un coffret ou panier, encore appelé tiroir ou rack. L'invention trouve une utilité particulière pour les équipements électroniques, en particulier les cartes d'alimentation, dont les composants s'échauffent de façon importante et qui nécessitent une évacuation rapide de la chaleur. L'invention est particulièrement intéressante pour les équipements électroniques embarqués, notamment refroidis par air ventilé.

On trouve, par exemple, des calculateurs comprenant plusieurs cartes électroniques disposées parallèlement les unes aux autres dans le coffret. Afin d'assurer la maintenance de l'équipement, les différentes cartes sont démontables. Le montage et le démontage des cartes se font par translation de celles-ci dans des rainures ou glissières du coffret.

On appelle circuit imprimé un circuit imprimé nu, c'est-à-dire sans composants électroniques et sans dispositif de dissipation de chaleur, et une carte électronique, un circuit imprimé équipé d'un dissipateur thermique et d'un ou plusieurs composants électroniques. Un circuit imprimé comprend ou est un assemblage d'une pluralité de couches conductrices séparées deux à deux d'une couche de matériau isolant ou un assemblage d'au moins une couche conductrice et d'une couche isolante. Les couches conductrices comprennent chacune des pistes conductrices. Elles sont par exemple obtenues par gravure. En fonctionnement, les composants de la carte électronique peuvent dissiper une grande quantité de chaleur. Cette chaleur doit être évacuée afin de maintenir une température de fonctionnement adéquate n'excédant pas une valeur maximale acceptable.

Plusieurs solutions ont été envisagées pour le refroidissement d'équipements électroniques : le refroidissement par convection thermique et le refroidissement par conduction thermique.

La convection thermique consiste à mettre un corps chaud en contact avec un fluide, de préférence mis en mouvement par rapport à la carte de manière à améliorer l'échange thermique entre les composants chauds et le fluide froid.

La conduction thermique est un mode de transfert thermique résultant d'une différence de température entre deux zones d'un même milieu ou entre deux milieux différents en contact.

Une solution connue pour le refroidissement des cartes électroniques consiste à équiper le circuit imprimé d'un drain thermique sous forme d'une plaque réalisée dans un matériau à forte conductivité thermique, comme par exemple du cuivre ou de l'aluminium. La plaque a sensiblement la même surface que le circuit imprimé et est parallèle à celui-ci. Cette plaque est fixée sur la face du circuit imprimé opposée à celle recevant les composants électroniques. Elle permet de conduire la chaleur à évacuer du circuit imprimé vers un échangeur thermique disposé au sein du coffret et plaqué contre le drain thermique, par exemple sous forme de canaux ou de plaques dans lesquels circule un liquide de refroidissement. Il est alors nécessaire de raccorder ces canaux ou plaques vers un réseau de refroidissement externe à l'équipement.

Cette solution est adaptée aux applications équipées d'un tel réseau de refroidissement. En revanche, ce type de solution se révèle insuffisamment efficace pour les applications dans lesquelles les coffrets ne sont pas équipés d'un réseau de refroidissement et qui sont généralement équipés uniquement d'un ventilateur.

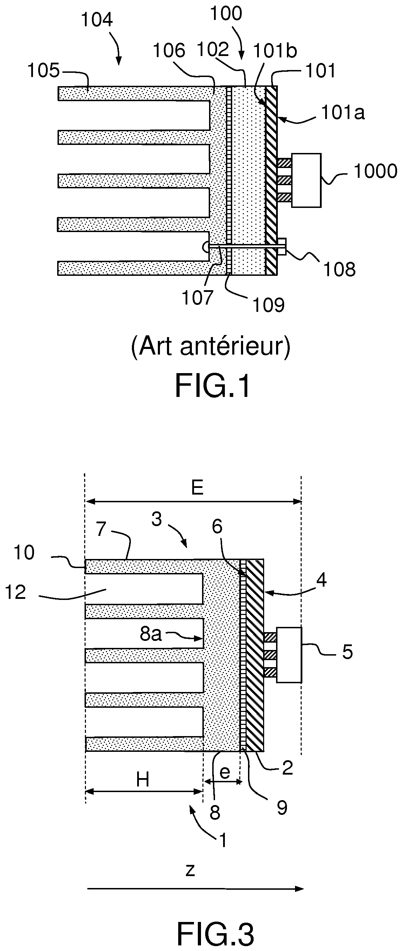

Pour corriger cet inconvénient, on vient classiquement visser un radiateur comprenant des ailettes de refroidissement sur la face du drain thermique opposée au circuit imprimé. Le radiateur, par ses ailettes, augmente la surface de contact entre la carte électronique et le fluide en contact avec la carte électronique, par exemple l'air. Il permet d'améliorer les performances de refroidissement par convection. Une solution de ce type est représentée sur la figure 1 sur laquelle sont visibles, la carte électronique 100 comprenant un circuit imprimé 101 comprenant deux faces 101a et 101b, un drain 102 fixé au circuit imprimé 101 (et plus précisément à la deuxième face 101b du circuit imprimé 101a), un composant 1000 fixé au circuit imprimé 101 (et plus précisément brasé sur la première face 101a), un radiateur 104 comprenant des ailettes de refroidissement 105 et une semelle fine 106 relativement au drain thermique. Le radiateur 104 est fixé au drain 102 et au circuit imprimé 101 au moyen d'une pluralité de systèmes vis 107-écrou 108, typiquement au moins une dizaine, dont un seul est visible sur la figure 1, la vis 107 traversant le drain 102 et le circuit imprimé 101, et une couche de graisse thermique 109 interposée entre le radiateur 104 et le drain 102 et assurant un bon échange thermique entre le radiateur 104 et le drain 102 en comblant les interstices entre ces deux éléments.

La demanderesse a constaté que ce type de carte présente un certain nombre d'inconvénients. La graisse est composée d'un mélange de deux phases comprenant une phase liquide (huile) qui est une graisse et une phase solide comprenant des particules conductrices en général en argent. Ces deux phases se séparent dans le temps et avec des augmentations de température ce qui a pour conséquence de diminuer les performances de dissipation d'énergie du système radiateur + drain et peut limiter les performances des autres cartes ou équipements insérés dans le coffret, voire détériorer leurs performances. La fixation du radiateur 104 au drain thermique 102 au moyen des systèmes vis-écrous 107-108 limite considérablement la surface utile du circuit imprimé. Il est en effet nécessaire de prévoir une zone d'isolation suffisante entre chaque système vis-écrou et les composants sur la face 101a du circuit imprimé recevant les composants.

Par ailleurs, les opérations de fixation du radiateur sur le drain thermique et d'application de la graisse thermique sont des opérations délicates devant être réalisées manuellement, qui sont par conséquent coûteuses.

En outre, les systèmes vis-écrous perturbent le flux d'air côté radiateur ce qui a pour effet de diminuer la maîtrise du refroidissement de la plaque électronique.

Enfin, ce type de solution présente une épaisseur importante. La demande de brevet français portant le numéro de publication FR2875372 divulgue une plaque support pour une carte de circuit imprimé selon le préambule de la revendication 1.

Le but de l'invention est de corriger tout ou partie des inconvénients précités.

A cet effet, l'invention a pour objet une carte électronique comprenant un assemblage d'un circuit imprimé comprenant une première face recevant au moins un composant électronique, et d'un dissipateur thermique, le circuit imprimé et le dissipateur thermique étant empilés selon une direction d'empilement, ledit dissipateur thermique étant fixé au circuit imprimé sur une deuxième face opposée à la première face, ledit dissipateur thermique comprenant une semelle, présentant la forme d'une plaque, et des reliefs dépassant d'une surface plane de ladite semelle, les reliefs étant destinés à augmenter la surface de contact entre le dissipateur thermique et un flux d'air par rapport à la surface de contact entre la semelle et le flux d'air, la semelle étant interposée entre le circuit imprimé et les reliefs selon la direction d'empilement. Le dissipateur thermique est fixé directement au circuit imprimé par collage uniquement et ledit dissipateur thermique est monobloc. Avantageusement, seule une couche adhésive sépare la semelle et le circuit imprimé, la couche adhésive comprenant une colle s'étendant continûment depuis la semelle jusqu'au circuit imprimé.

Avantageusement, la couche adhésive est un film de colle.

Avantageusement, la couche adhésive comprend des fibres imprégnées de colle.

Avantageusement, la couche adhésive est un isolant électrique.

Avantageusement, la colle est thermodurcissable.

Avantageusement, le dissipateur thermique est en métal.

Avantageusement, la couche adhésive présente une épaisseur inférieure ou égale à 200 micromètres et de préférence comprise entre 100 micromètres et 200 micromètres.

Avantageusement, le dissipateur thermique présente une épaisseur comprise entre 5 mm et 20 mm.

Avantageusement, le circuit imprimé présente une épaisseur comprise entre 0,1 mm et 1 mm.

Avantageusement, le dissipateur thermique s'étend sensiblement sur toute la surface utile du circuit imprimé

Avantageusement, le dissipateur thermique est fixé au circuit imprimé par collage au moyen d'un film de colle interposé entre la semelle et le circuit imprimé selon la direction d'empilement.

L'invention se rapporte également à un procédé de fabrication d'une carte électronique comprenant :
- Une étape d'empilement dans laquelle on place le dissipateur thermique de façon que la semelle soit interposée entre les reliefs et la deuxième face du circuit imprimé et dans laquelle on dispose une couche adhésive entre la deuxième face du circuit imprimé et la semelle, la couche adhésive comprenant une colle s'étendant continûment sur toute l'épaisseur de la colle selon la direction d'empilement,
- Une étape d'assemblage consistant à assembler le dissipateur thermique et le circuit imprimé lors de laquelle on soumet l'empilement obtenu à une compression à chaud.

Avantageusement, l'étape d'assemblage est réalisée au moyen d'une presse comprenant un outillage comprenant une portion configurée et agencée par rapport au dissipateur thermique de sorte à venir en appui sur la surface de laquelle dépassent les reliefs et s'étendant entre les reliefs.

Avantageusement, l'étape d'assemblage est réalisée au moyen d'une presse comprenant un outillage comprenant une portion configurée et agencée par rapport au dissipateur thermique de sorte à venir en appui sur la totalité de la surface de laquelle dépassent les reliefs et s'étendant entre les reliefs.

Avantageusement, l'étape d'assemblage est réalisée au moyen d'une presse comprenant un outillage comprenant une portion configurée et agencée par rapport au dissipateur thermique de sorte à venir en appui sur les reliefs selon la direction z.

Avantageusement, le circuit imprimé est multicouches et dans lequel l'étape d'assemblage est une étape d'assemblage d'une pluralité de couches du circuit imprimé.

Avantageusement, l'assemblage du dissipateur thermique et du circuit imprimé est réalisé par polymérisation de la colle.

D'autres caractéristiques et avantages de l'invention apparaîtront à la lecture de la description détaillée qui suit, faite à titre d'exemple non limitatif et en référence aux dessins annexés dans lesquels :
- la figure 1 déjà décrite représente schématiquement en coupe une carte électronique de l'art antérieur,
- la figure 2 représente schématiquement un coffret recevant une carte électronique selon l'invention sur laquelle les composants électroniques et le radiateur n'ont pas été représentés pour plus de clarté,
- la figure 3 représente schématiquement une coupe d'une carte électronique selon l'invention,
- la figure 4 représente un schéma synoptique des étapes du procédé selon l'invention,
- la figure 5 représente schématiquement une presse utilisée dans le procédé selon l'invention.

D'une figure à l'autre, les mêmes éléments sont repérés par les mêmes références.

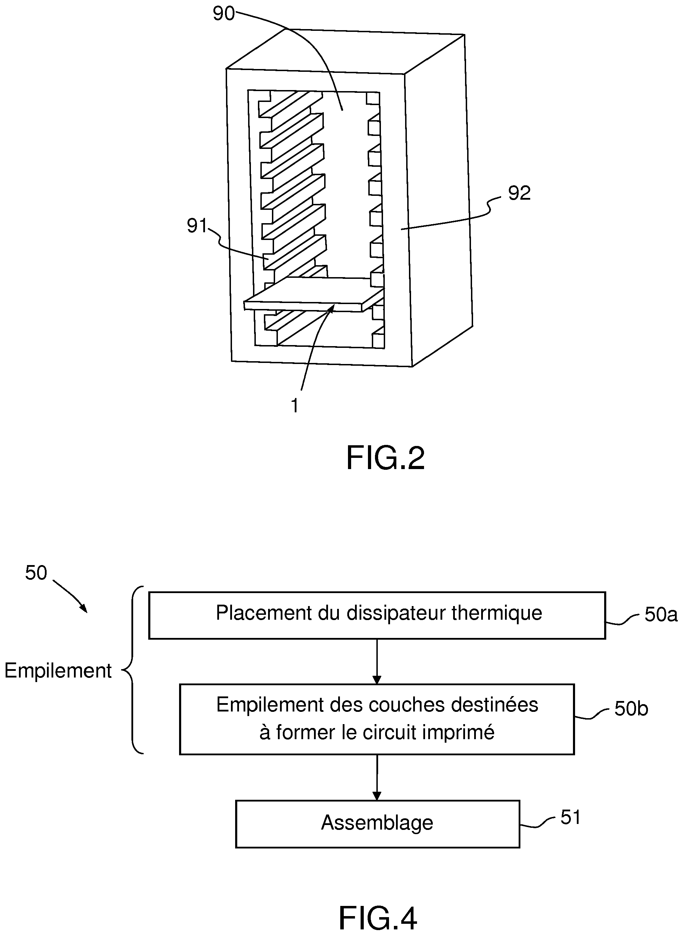

La figure 2 représente un coffret 90 comprenant une pluralité de glissières 91 s'étendant longitudinalement parallèlement les unes aux autres. Le coffret 90 reçoit une carte électronique 1 selon l'invention. La carte électronique 1 est maintenue dans le châssis 92 du coffret 90 au niveau des glissières 91 perpendiculaires au fond du panier.

La figure 3 représente en perspective une coupe d'une plaque électronique selon l'invention selon un plan parallèle à la direction d'empilement.

La plaque électronique 1 comprend un assemblage d'un circuit imprimé 2 et d'un dissipateur thermique 3. Le circuit imprimé 2 est du type comprenant une pluralité de couches individuelles non représentées sur la figure 1. Il comprend au moins une couche conductrice et au moins une couche isolante. Chaque couche conductrice comprend des pistes conductrices électriquement. Ces pistes sont classiquement en cuivre. En variante, les pistes sont réalisées dans un matériau autre que le cuivre. Le circuit imprimé peut être du type simple face (comprenant une couche conductrice et une couche isolante), double face (comprenant deux couches conductrices séparées par une couche isolante), ou multicouches (comportant au moins trois couches conductrices séparées deux à deux par une couche isolante). Les couches conductrices sont par exemple formées à partir de couches de cuivre. Ces couches de cuivre, ou couches conductrices individuelles du circuit imprimé sont par exemple gravées de sorte à former des pistes. Par couche isolante, on entend une couche isolante électriquement et par couche conductrice, on entend une couche conductrice électriquement.

Le circuit imprimé 2 comprend une première face 4 destinée à recevoir un ou plusieurs composants électroniques. Un seul composant électronique 5 est visible sur la figure 3. La première face 4 peut recevoir plusieurs composants électroniques. Tous les composants électroniques fixés sur le circuit imprimé 2 sont reçus par la première face 4. Autrement dit, chaque composant électronique est fixé, de préférence brasé, sur la première face 4.

Le circuit imprimé 2 et le dissipateur thermique 3 sont empilés selon une direction d'empilement ou d'empilage z. Les couches individuelles, non représentées, du circuit imprimé 2 sont aussi empilées selon la direction d'empilement z. Le dissipateur thermique 3 est fixé au circuit imprimé sur une deuxième face 6 du circuit imprimé 2. La deuxième face 6 est opposée à la première face 4. Les première et deuxième faces sont parallèles entre elles et perpendiculaires à la direction d'empilement z.

Le dissipateur thermique 3 s'étend sensiblement sur toute la surface utile du circuit imprimé. Autrement dit, le dissipateur thermique peut s'étendre sur toute la surface du circuit imprimé ou bien, en variante, s'étendre sur la surface utile du circuit imprimé s'étendant entre deux glissières maintenant le circuit imprimé dans le coffret sans s'étendre à l'intérieur des deux glissières.

Le dissipateur thermique 3 comprend des ailettes de refroidissement 7 et une semelle 8. La semelle 8 est interposée entre les ailettes de refroidissement 7 et le circuit imprimé 2 selon la direction d'empilement z. Le dissipateur thermique 3 présente un profil en forme de peigne dans le plan de la figure. La semelle 8 assure une fonction de drain thermique permettant d'évacuer la chaleur transmise par les composants au circuit imprimé 2 depuis la deuxième face 6 du circuit imprimé 2 vers les ailettes 7.

La semelle 8 présente la forme d'une plaque. La plaque s'étend selon son épaisseur e, parallèlement à la direction d'empilement z. Elle est plaquée contre le circuit imprimé. La semelle 8 est épaisse relativement au circuit imprimé 2. Le circuit imprimé 2 présente typiquement une épaisseur comprise entre 0,10 et 1 mm. La semelle 8 présente une épaisseur au moins égale à 2 mm. Typiquement, la semelle 8 présente une épaisseur comprise entre 2 et 5 mm. Toutefois, cet intervalle n'est pas limitatif dans la mesure où les dimensions de la semelle et des ailettes de refroidissement sont déterminées en fonction de l'épaisseur du circuit imprimé, en fonction de l'épaisseur de la carte électronique souhaitée et en fonction des performances thermiques souhaitées.

Dans une réalisation particulière le dissipateur thermique 3 assure une fonction de raidisseur du circuit imprimé 2. Dans ce cas, la semelle 8 présente une raideur supérieure à celle du circuit imprimé. En variante, le circuit imprimé présente une raideur au moins égale à la semelle du dissipateur thermique.

Les ailettes de refroidissement 7 permettent d'améliorer l'évacuation de la chaleur (dissipée par le circuit imprimé 2 du fait du réchauffement des composants) par convection par rapport à un dissipateur thermique sous forme de plaque en augmentant la surface de contact entre le dissipateur thermique et le fluide en contact avec ce dernier par rapport à la surface de contact entre la semelle 8 et le flux d'air, c'est-à-dire la surface libre de la semelle. Autrement dit, un dissipateur thermique comprenant les ailettes de refroidissement, c'est-à-dire formé de la semelle munie des ailettes de refroidissement, présente avec l'air une surface de contact supérieure à celle d'un dissipateur thermique comprenant uniquement la semelle. Chaque ailette 7 présente la forme d'une plaque s'étendant longitudinalement selon une direction parallèle à une direction perpendiculaire au plan de la figure 3 et présentant, dans le plan de la figure 3, la forme d'une tige s'étendant longitudinalement, selon la direction d'empilement z, depuis la semelle 8 jusqu'à une extrémité libre 10. Les ailettes 7 s'étendent depuis une surface 8a plane de la semelle opposée au circuit imprimé 2 selon la direction d'empilement z. La surface plane 8a est discontinue. Elle est formée par une pluralité de portions séparées par les ailettes. Les ailettes 7 présentent une hauteur H typiquement au moins égale à 2 mm et typiquement comprise entre 2 et 15 mm. Comme pour la semelle, cet intervalle n'est pas limitatif puisque les dimensions de la semelle dépendent de plusieurs paramètres comme expliqué précédemment. Le plan de la figure 3 est un plan contenant la direction d'empilement et perpendiculaire à la direction longitudinale des ailettes. La hauteur H des ailettes est la dimension des ailettes selon la direction d'empilement z.

Les ailettes 7 sont séparées deux à deux par des tranchées 12. Les tranchées 12 s'étendent longitudinalement parallèlement à la direction longitudinale des ailettes. Les tranchées présentent une section en U dans le plan de la figure 3. Le fond de chaque U est formé par une portion de la surface 8a de la semelle 8 opposée au circuit imprimé 2 et les bras de chaque U sont formés par deux ailettes 7 adjacentes. La section des ailettes est constante. Autrement dit, elles présentent des dimensions constantes le long de la direction selon laquelle elles s'étendent longitudinalement (direction perpendiculaire au plan de la figure 3). Par conséquent, les tranchées présentent aussi une section constante.

Selon l'invention, le dissipateur thermique 3 est monobloc. Autrement dit, les ailettes 7 et la semelle 8 sont formées dans une seule pièce. Cela signifie que le dissipateur thermique 3 est réalisé dans un seul matériau. Ce matériau peut être homogène. En variante, il est composite.

Cette pièce est de préférence mais non nécessairement pleine, par opposition à creuse. Le dissipateur thermique peut être réalisé dans un matériau présentant une forte conductivité thermique. Il est par exemple réalisé en métal, de préférence en aluminium, ou en cuivre. Selon l'invention, le dissipateur thermique est fixé directement au circuit imprimé 2 uniquement par collage. Autrement dit, le dissipateur thermique 3 est fixé au circuit imprimé au moyen d'un film de colle 9 interposé entre le dissipateur thermique et le circuit imprimé 2. Plus précisément, le film de colle 9 est interposé entre la semelle 8 et le circuit imprimé 2. Par dissipateur thermique fixé directement au circuit imprimé par collage, on entend que le circuit imprimé et le dissipateur thermique sont séparés uniquement par un film de colle 9.

De manière plus générale, selon l'invention le dissipateur thermique est fixé au circuit imprimé au moyen d'une couche adhésive. Le circuit imprimé et le dissipateur sont séparés uniquement par cette couche adhésive.

Avantageusement, la couche adhésive comprend une colle qui s'étend continument depuis le circuit imprimé jusqu'à la semelle.

La couche adhésive peut être une colle, c'est-à-dire un film de colle. En variante, la couche adhésive est une couche fibreuse comprenant des fibres imprégnées de colle. Les fibres sont, dans un exemple non limitatif, des fibres de verre.

Dans ce type de couche adhésive, la colle passe avantageusement entre les fibres de sorte qu'elle s'étend continument depuis le circuit imprimé jusqu'à la semelle. La couche fibreuse peut être un tissu imprégné de colle, autrement-dit elle comprend des fibres tissées imprégnées de colle. En variante, la couche fibreuse est un mat imprégné de colle. Ce type de couche adhésive présente l'avantage d'être facile à appliquer.

De préférence mais non nécessairement, la colle est en contact du circuit imprimé et du dissipateur sensiblement sur toute la surface du dissipateur.

Avantageusement, le collage du dissipateur thermique au circuit imprimé est réalisé par polymérisation de la colle. La couche adhésive comprend alors de polymères.

Le film de colle 9, ou de manière plus générale la couche adhésive, est un isolant électrique. Autrement dit cette couche est réalisé en matériau isolant électriquement. Plus précisément, elle est réalisée dans un ou plusieurs matériaux qui est (sont) isolant(s) électriquement. Cela permet d'éviter la formation d'un court-circuit entre le circuit imprimé (notamment avec la couche du circuit imprimé qui est en regard du film de colle) et le dissipateur thermique formant classiquement la masse mécanique.

Dans le cas d'une couche fibreuse, la colle et les fibres sont formées dans des matériaux isolants électriquement. Dans le cas du film de colle, la colle est un isolant électrique.

Le film de colle, ou plus généralement la couche adhésive, présente une épaisseur inférieure ou égale à 200 micromètres. Il présente de préférence une épaisseur minimale de 100 micromètres et typiquement comprise entre 100 et 200 micromètres. Elle permet de bien compenser les défauts de surfaces de la semelle et du radiateur.

La colle est, de préférence mais non nécessairement, thermodurcissable. La couche adhésive s'étend sur toute la surface de la semelle 8 en regard du circuit imprimé. Ces caractéristiques sont liées au procédé d'assemblage utilisé et décrit dans la suite du texte. L'épaisseur réduite du film de colle permet un transfert thermique très efficace entre le circuit imprimé et le dissipateur thermique 3. Par ailleurs, la couche adhésive permet de limiter les risques de formation de bulles d'air en pénétrant dans les aspérités des deux surfaces. Elle peut être utilisée pour fixer entre elles de grandes surfaces et à basse température permettant de préserver l'intégrité du circuit imprimé.

La colle est de préférence réalisée à base de résine époxyde ou est du type colle acrylique. En variante, de façon non limitative, la colle est une colle polyuréthane, cyanoacrylate, élastomère ou silicone.

Le fait que le dissipateur thermique, assurant la double fonction d'évacuation de la chaleur par convection thermique (ailettes) et conduction thermique (drain ou semelle), soit monobloc et fixé uniquement par collage au circuit imprimé apporte un certain nombre d'avantages. Il peut être fixé en une seule étape de collage non manuelle au circuit imprimé, ce qui limite le coût de l'assemblage de la plaque électronique et permet d'offrir une surface d'implantation des composants électroniques 5 importante du côté de la première face 4 du circuit imprimé 2. Le dissipateur thermique 3 présente une unique interface avec le circuit imprimé 2 (film de colle 9 ou couche adhésive) ce qui implique que le transfert thermique entre ces deux éléments est meilleur que lorsque le dissipateur thermique est du type comprenant une semelle et un radiateur liés entre eux par des vis et séparés par une graisse thermique. Cette augmentation des performances en termes de dissipation d'énergie thermique permet, pour un circuit imprimé donné, des composants électroniques donnés et des performances en termes d'évacuation de la chaleur données, de diminuer l'épaisseur du dissipateur thermique. L'épaisseur du dissipateur thermique est donnée par l'épaisseur de la semelle 8 et la hauteur H des ailettes de refroidissement 7. L'invention permet typiquement de réaliser des cartes électroniques pouvant rentrer dans l'espace alloué à une unique carte électronique dans un rack ou tiroir selon la norme VME64 tout en obtenant les performances en termes de dissipation de chaleur souhaitées, notamment pour une carte d'alimentation ce qui n'était pas possible avec les dispositifs de l'art antérieur. Typiquement, le dissipateur thermique présente une épaisseur comprise entre 5 et 20 mm selon la direction d'empilement ce qui permet de réaliser des cartes électroniques présentant une épaisseur E inférieure ou égale à 20,32 mm selon la direction d'empilement correspondant à l'épaisseur allouée à une carte électronique dans la norme VME. La carte électronique selon l'invention présente un poids limité.

Par ailleurs, l'invention permet d'assembler le dissipateur thermique lors d'une unique étape d'assemblage qui peut être l'étape d'assemblage du circuit imprimé dans le cas d'un circuit imprimé multicouches. Dans ce dernier cas, la fixation du dissipateur thermique sur le circuit imprimé n'est pas une étape supplémentaire d'assemblage ultérieure à l'étape d'assemblage du circuit imprimé.

L'invention a été décrite en référence à un mode de réalisation dans lequel le dissipateur thermique comprend des ailettes de refroidissement. Ces ailettes sont des reliefs, c'est-à-dire des structures en saillie sur une surface plane 8a de la semelle 8. Les reliefs sont destinés à augmenter la surface de contact entre le dissipateur thermique 3 et un flux d'air par rapport à la surface de contact entre la semelle 8 (dépourvue de relief) et le flux d'air. Ce mode de réalisation n'est pas limitatif. On envisage un mode de réalisation dans lequel les reliefs ont la forme de picots, c'est-à-dire de plots ou de tiges s'étendant longitudinalement selon la direction d'empilement. Les picots s'étendent longitudinalement selon la direction d'empilement z depuis la semelle 8 jusqu'à une extrémité libre. En variante, le dissipateur thermique comprend au moins une ailette de refroidissement et au moins un picot.

Plus généralement, l'invention se rapporte à une carte électronique dans laquelle le dissipateur thermique comprend une semelle 8 telle que décrite précédemment et des reliefs à la surface de ladite semelle, les reliefs étant destinés à augmenter la surface de contact entre le dissipateur thermique et un flux d'air par rapport à la surface de contact entre la semelle et le flux d'air. Les reliefs dépassent d'une surface plane 8a de la semelle selon la direction d'empilement z. Plus précisément, ces reliefs dépassent de la surface plane 8a qui est la surface de la semelle opposée au circuit imprimée selon la direction d'empilement z. La surface plane 8a s'étend entre les reliefs. La surface plane 8a est discontinue lorsque les reliefs sont des ailettes et continue lorsque les reliefs sont des picots. Les reliefs sont par exemple, de façon non limitative, des picots ou des ailettes.

Tout ce qui a été dit précédemment avec les ailettes de refroidissement est aussi valable avec les picots et de manière générale, avec les reliefs à la surface de la semelle.

L'invention se rapporte également à un procédé de fabrication d'une carte électronique 1 selon l'invention.

La figure 4 représente un schéma synoptique des étapes du procédé selon l'invention.

Le procédé de fabrication de la carte électronique selon l'invention comprend :
- Une étape d'empilement 50, selon la direction d'empilement, comprenant une première étape 50a consistant à placer le dissipateur thermique 3 de façon que la semelle 8 soit interposée entre les reliefs qui sont par exemple des ailettes 7 et la deuxième face 6 du circuit imprimé 2 et à disposer une couche de colle 9, ou plus généralement la couche adhésive, entre la deuxième face 6 du circuit imprimé et la semelle 8,
- Une étape d'assemblage 51 du dissipateur thermique 3 et du circuit imprimé 2 lors de laquelle on soumet l'empilement obtenu lors de l'étape d'empilement 50 à une compression à chaud.

L'étape d'assemblage 51 est réalisée de sorte à assembler la semelle au circuit imprimé par collage au moyen de la couche adhésive comprenant la colle. Lors de l'étape d'assemblage 51, le circuit imprimé est avantageusement collé au dissipateur thermique par polymérisation de la colle.

Avantageusement, la colle durcit pendant l'étape d'assemblage. Elle est liquide, pâteuse ou visqueuse lors de l'application de la couche adhésive pendant la phase d'empilement 50.

Lors de l'étape d'empilement 50, on dépose une couche adhésive comprenant une colle s'étendant continûment sur toute l'épaisseur de la couche adhésive, selon la direction d'empilement.

Lors de l'étape d'empilement 50, on empile le dissipateur thermique 3 et le circuit imprimé 2 ou les couches destinées à former le circuit imprimé 2 et le dissipateur thermique selon la direction d'empilement z de façon à obtenir un empilement 11. Lors de l'étape d'empilement 50, la couche de colle 9 ou la couche adhésive est appliquée sur la deuxième face 6 du circuit imprimé 2 et/ou sur la face de la semelle 8 en regard de la deuxième face 6 du circuit imprimée 2. Lors de l'étape d'assemblage 51 la compression est réalisée selon la direction d'empilement z. Par compression à chaud, on entend une étape de compression de l'empilement lors de laquelle l'empilement obtenu est chauffé.

Les composants électroniques 5 sont ensuite rapportés sur le circuit imprimé 2 et plus précisément sur la deuxième face du circuit imprimé. Avantageusement, les pistes sont gravées antérieurement à l'étape 50.

Avantageusement, le circuit imprimé 2 est un circuit imprimé multicouches. L'étape d'empilement 50 comprend une deuxième étape 50b d'empilement d'une pluralité de couches destinées à former le circuit multicouches selon la direction d'empilement z. Ces couches sont des ensembles double-face.

L'étape d'assemblage 51 du dissipateur thermique 3 et du circuit imprimé 2 est alors avantageusement une étape d'assemblage du circuit imprimé 2, c'est-à-dire une étape d'assemblage des ensembles double face destinés à former le circuit imprimé multicouches, c'est-à-dire une étape d'assemblage d'une pluralité de couches du circuit imprimé. L'étape d'assemblage 51 est réalisée en pressant l'empilement obtenu lors de l'étape 50 selon la direction d'empilement. Il s'agit d'une étape dite de stratification. En variante, le circuit imprimé est multicouches mais les couches ou une partie des couches du circuit imprimé sont assemblées avant l'étape d'assemblage 51. C'est, par exemple, le cas lorsque des couches doivent être interconnectées entre elles. Elles sont assemblées préalablement à l'étape d'assemblage du dissipateur thermique avec le circuit imprimé.

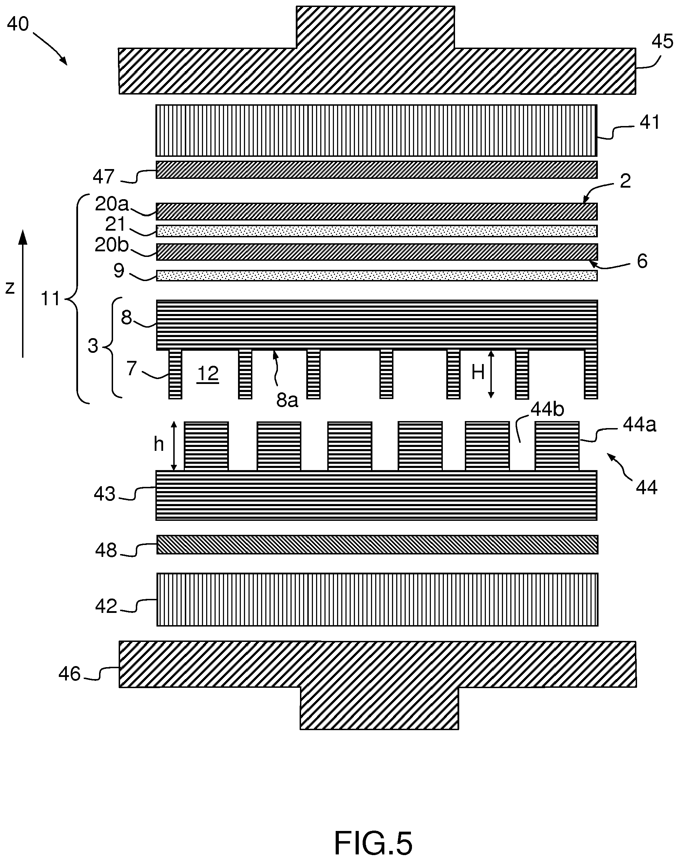

La figure 5 représente schématiquement une presse 40 permettant de réaliser l'étape d'assemblage 51 du procédé selon l'invention. Dans ce mode de réalisation, les reliefs sont des ailettes.

La presse 40 comprend deux outillages 41, 42. L'empilement est réalisé entre ces deux outillages 41, 42. Chaque outillage 41, 42 est constitué d'une plaque disposée en regard de l'empilement 11.

La presse comprend un outillage de reprise d'efforts 43. L'outillage est adjacent au dissipateur thermique de sorte à venir en appui sur lui lors du pressage. L'outillage 43 comprend une portion 44 présentant une forme sensiblement complémentaire de la partie du dissipateur thermique 3 opposée au circuit imprimé 2 selon la direction z. Autrement dit, la portion 44 de l'outillage 43 présente une forme sensiblement complémentaire de la partie du dissipateur thermique formée par les ailettes de refroidissement 7 et la surface 8a de la semelle 8 de laquelle elles dépassent. Lors de l'étape d'assemblage 51, le dissipateur thermique 3 et l'outillage 43 coopèrent de sorte que la portion 44 forme sensiblement l'empreinte de la partie du dissipateur thermique 3 opposée au circuit imprimé, c'est-à-dire de la partie du dissipateur thermique 3 formée par les ailettes de refroidissement 7 et par la surface de la semelle de laquelle elles dépassent. En d'autres termes, la portion 44 de l'outillage 43 épouse sensiblement la forme des ailettes de refroidissement 7 et de la surface 8a de laquelle elles dépassent.

En d'autres termes, l'outillage 43 présente une portion 44 destinée à coopérer avec le dissipateur thermique. Cette portion 44 présente des ailettes de l'outillage 44a séparées deux à deux par des tranchées 44b de l'outillage 44b. Les tranchées de l'outillage 44a et les ailettes de l'outillage 44b sont configurées et agencées les unes par rapport aux autres de sorte que la portion 44 présente une forme sensiblement complémentaire de celle formée par les ailettes 7 et les tranchées 12 du dissipateur thermique 3. Sur la réalisation non limitative des figures 3 et 5, les ailettes 7 présentent les mêmes dimensions dans le plan de la figure 3 et sont régulièrement espacées, selon une direction perpendiculaire à la direction d'empilement z dans le plan de la figure 3, et séparées par des tranchées 12 présentant toutes les mêmes dimensions dans le plan de la figure 3. Les ailettes de l'outillage 44a présentent par conséquent une section sensiblement identique à celle des tranchées 12 et les tranchées de l'outillage présentent des dimensions sensiblement identiques à celles des ailettes 7.

Lors de l'étape 51, l'outillage 43 et le dissipateur thermique 3 sont disposés l'un par rapport à l'autre de façon que les ailettes de l'outillage 44a pénètrent dans les tranchées 12 et que les ailettes 7 pénètrent dans les tranchées de l'outillage 44a. L'outillage vient alors en appui sur la totalité de la surface 8a de laquelle dépassent les ailettes 7 et sur les ailettes 7 lors de l'étape de pressage.

Les outillages 41, 42, 43 sont par exemple des pièces en acier ou en aluminium. L'outillage 43 est de préférence réalisé dans un matériau présentant un coefficient de dilatation thermique sensiblement identique à celui du dissipateur thermique 3 entre la température ambiante et la température de chauffage.

Les outillages 41, 42, 43 sont ensuite transférés dans les compartiments de la presse à plateaux 40. Les plateaux 45, 46 sont aptes à être rapprochés et écartés les uns des autres à l'aide d'un dispositif non représenté, par exemple du type comprenant des vérins. Les outillages 41, 42, 43 sont mis en compression, selon la direction d'empilement z par rapprochement des deux plateaux 45, 46 l'un par rapport à l'autre selon la direction d'empilement z. Un circuit de chauffage non représenté assure réchauffement des outillages 41, 42, 43 ou 41, 43 à l'aide d'un circuit de chauffage au moins partiellement incorporés dans les plateaux 45, 46 de manière à chauffer l'empilement 11 obtenu lors de l'étape 50.

Avantageusement, un matelas déformable 47, 48 est interposé entre l'outillage 41 et les couches 20a, 20b destinées à former le circuit imprimé 2 et entre l'outillage 42 et l'outillage 43.

Avantageusement, la pression appliquée sur l'empilement 11 lors de l'étape d'assemblage 51 est typiquement comprise entre 30 et 40 bars et l'empilement est chauffé à une température typiquement comprise entre 120 et 180°C. La température appliquée dépend de la température de polymérisation de la colle utilisée. La pression et la température sont appliquées pendant une durée typiquement comprise entre 1h30 et 3h30. Cette durée dépend du cycle de polymérisation de la colle utilisée.

Sur la réalisation de la figure 5, une pluralité de couches 20a, 20b destinées à former le circuit imprimé 2 sont empilées selon la direction z. Ces couches sont typiquement des doubles-faces. Une couche de colle 21 est interposée entre ces deux couches c'est-à-dire appliquée sur au moins l'une des deux couches en regard.

La forme de l'outillage 43 permet de réaliser une fixation performante du dissipateur thermique 3 sur le circuit imprimé 2 sans déformation des ailettes de refroidissement 7 et sans galber l'ensemble formé par le circuit imprimé 2 et le dissipateur thermique 3. Il permet d'appliquer une pression sensiblement uniforme sur toute la surface du dissipateur thermique dans un plan perpendiculaire à la direction d'empilement ce qui assure un collage du dissipateur thermique sur le circuit imprimé sur toute la surface de la face du dissipateur thermique située en regard du circuit imprimé. Il permet d'éviter la formation de bulles d'air à l'interface entre le dissipateur thermique 3 et le circuit imprimé 2. Cela permet de limiter les risques de délaminage de la carte électronique et ainsi la diminution de ses performances dans le temps sous l'effet de changements de températures.

De manière plus générale, l'étape d'assemblage 51 est réalisée au moyen d'une presse comprenant un outillage 42 comprenant une portion 44 configurée de manière à présenter une forme sensiblement complémentaire de la partie du dissipateur thermique 3 formée par les reliefs 7 et par la surface 8a, de la semelle 8, de laquelle ils dépassent. Par ailleurs lors de cette étape, le dissipateur thermique 3 et l'outillage 42 sont agencés de sorte à coopérer de façon que la portion 44 du deuxième outillage 42 forme sensiblement l'empreinte de la partie du dissipateur thermique 3 formée par les reliefs 7 et par la surface 8a, de la semelle 8, de laquelle ils dépassent.

Par, une portion 44 de l'outillage 43 forme sensiblement l'empreinte de la partie du dissipateur thermique 3 formée par les reliefs 7 (ou ailettes) et par la surface 8a de la semelle 8 de laquelle dépassent les reliefs, on entend que la portion 44 présente une forme complémentaire des reliefs 7 et de la surface 8a au jeu de fonctionnement près. Le jeu de fonctionnement est défini de façon à éviter les coincements entre l'outillage 43 et le dissipateur thermique 3 lors du pressage, c'est-à-dire lors de l'étape 51, et de façon que l'outillage 43 vienne en appui sur la totalité de la surface des reliefs et de la surface 8a s'étendant entre les reliefs. Autrement dit, lors de l'étape d'assemblage 51, le dissipateur thermique et l'outillage 43 se déforment de façon à venir combler les jeux entre eux. L'outillage est configuré et disposé par rapport au dissipateur thermique de manière à venir en appui sur la totalité de la surface 8a et sur les reliefs 7 selon la direction z.

Dans une variante, la portion 44 de l'outillage 43 forme, lors de l'étape 51, sensiblement l'empreinte de la au moins une partie creuse 12 s'étendant entre les reliefs 7 et étant délimitées par la surface 8a. Autrement dit, la portion 44 est configurée et agencée par rapport au dissipateur thermique 3 de sorte à présenter au moins un relief sensiblement complémentaire de la au moins une partie creuse s'étendant entre les reliefs 7. Cette complémentarité est réalisée au jeu de fonctionnement près de façon à éviter les coincements entre l'outillage 43 et le dissipateur thermique 3 lors du pressage, c'est-à-dire lors de l'étape 51 et de façon que l'outillage 43 vienne en appui sur la totalité de la surface 8a s'étendant entre les reliefs. Par conséquent, la portion 44 est configurée et agencée par rapport au dissipateur thermique, lors de l'étape 51, de sorte à venir en appui sur la totalité de la surface 8a de laquelle dépassent les reliefs 7. Dans une variante moins avantageuse, la forme de la portion 44 est définie de sorte qu'elle vienne en appui sur une partie de la surface 8a.

Dans le cas d'un dissipateur à picots, la portion de l'outillage présente un relief s'étendant continûment être les picots et dans le cas d'un dissipateur thermique 3 à ailettes 7, la portion 44 comprend plusieurs reliefs (ou ailettes) 44a sensiblement complémentaires des gorges 12. Par exemple, la hauteur h des reliefs de l'outillage 43 est supérieure à celle des reliefs 7 du dissipateur thermique et définie de sorte que le jeu entre l'outillage et les reliefs n'est pas rattrapé lors de l'étape de pressage. Cela permet d'éviter que les ailettes 7, partie la plus fragile du dissipateur thermique, n'aient à supporter l'effort de pressage. Cela permet d'atteindre une bonne uniformité de collage sur la surface du dissipateur thermique entre les reliefs 7.

Le procédé selon l'invention permet d'obtenir une carte électronique dans laquelle le film de colle ou plus généralement la couche adhésive présente une épaisseur typiquement comprise entre 100 et 200 micromètres. Cela permet de garantir une bonne efficacité de transfert thermique entre le dissipateur 3 et le circuit imprimé 2. Par ailleurs, la colle déborde autour du dissipateur thermique dans un plan perpendiculaire à la direction d'empilement z. Ce débordement est dû à un fluage de la colle lors de l'étape 51. Par ailleurs, la colle est avantageusement polymérisée.

L'outillage 43 décrit peut être utilisé même lorsque le circuit imprimé n'est pas multicouches.

Les intervalles donnés dans la présente demande de brevet sont les intervalles préférentiels mais ils ne sont pas limitatifs, les mesures, durées pouvant être situés en dehors de ces intervalles.

## Revendications

1. Carte électronique (1) comprenant un assemblage d'un circuit imprimé (2) comprenant une première face (4) recevant au moins un composant électronique, et d'un dissipateur thermique (3), le circuit imprimé (2) et le dissipateur thermique (3) étant empilés selon une direction d'empilement (z), ledit dissipateur thermique (3) étant fixé au circuit imprimé sur une deuxième face (6) opposée à la première face (4), ledit dissipateur thermique (3) comprenant une semelle (8), présentant la forme d'une plaque, et des reliefs (7) dépassant d'une surface plane (8a) de ladite semelle (8), les reliefs (7) étant destinés à augmenter la surface de contact entre le dissipateur thermique (3) et un flux d'air par rapport à la surface de contact entre la semelle (8) et le flux d'air, la semelle (8) étant interposée entre le circuit imprimé (2) et les reliefs (7) selon la direction d'empilement (z), **caractérisé en ce que** le dissipateur thermique (3) est fixé au circuit imprimé (2) par collage uniquement de sorte que seule une couche adhésive (9) sépare la semelle (8) et le circuit imprimé (2), la couche adhésive comprenant une colle s'étendant continûment depuis la semelle (8) jusqu'au circuit imprimé (2), et **en ce que** ledit dissipateur thermique (3) est monobloc.

2. Carte électronique selon la revendication précédente, dans laquelle la couche adhésive est un film de colle.

3. Carte électronique selon la revendication 1, dans laquelle la couche adhésive comprend des fibres imprégnées de colle.

4. Carte électronique selon l'une quelconque des revendications précédentes, dans laquelle la couche adhésive est un isolant électrique.

5. Carte électronique selon l'une quelconque des revendications précédentes, dans laquelle la colle est thermodurcissable.

6. Carte électronique selon l'une quelconque des revendications précédentes, dans laquelle le dissipateur thermique est en métal.

7. Carte électronique selon l'une quelconque des revendications précédentes, dans laquelle la couche adhésive présente une épaisseur inférieure ou égale à 200 micromètres.

8. Carte électronique selon la revendication précédente, dans laquelle la couche adhésive présente une épaisseur comprise entre 100 micromètres et 200 micromètres.

9. Carte électronique selon l'une quelconque des revendications précédentes, dans laquelle le dissipateur thermique présente une épaisseur comprise entre 5 mm et 20 mm.

10. Carte électronique selon l'une quelconque des revendications précédentes, dans laquelle le circuit imprimé présente une épaisseur comprise entre 0,1 mm et 1 mm.

11. Carte électronique selon l'une quelconque des revendications précédentes, dans laquelle le dissipateur thermique (3) s'étend sensiblement sur toute la surface utile du circuit imprimé (2).

12. Procédé de fabrication d'une carte électronique selon l'une quelconque des revendications précédentes, **caractérisé en ce qu'**il comprend :
- Une étape d'empilement (50) selon la direction d'empilement dans laquelle on place le dissipateur thermique (3) de façon que la semelle (8) soit interposée entre les reliefs (7) et la deuxième face (6) du circuit imprimé (2) et dans laquelle on dispose une couche adhésive (9)entre la deuxième face (6) du circuit imprimé et la semelle (8), la couche adhésive comprenant une colle s'étendant continûment sur toute l'épaisseur de la colle selon la direction d'empilement,
- Une étape d'assemblage (51) consistant à assembler le dissipateur thermique (3) et le circuit imprimé (2) lors de laquelle on soumet l'empilement obtenu à une compression à chaud.

13. Procédé de fabrication d'une carte électronique selon la revendication précédente, dans lequel l'étape d'assemblage (51) est réalisée au moyen d'une presse comprenant un outillage (42) comprenant une portion (44) configurée et agencée par rapport au dissipateur thermique (3) de sorte à venir en appui sur la surface (8a) de laquelle dépassent les reliefs (7) et s'étendant entre les reliefs (7).

14. Procédé de fabrication d'une carte électronique selon la revendication précédente, dans lequel l'étape d'assemblage (51) est réalisée au moyen d'une presse comprenant un outillage (42) comprenant une portion (44) configurée et agencée par rapport au dissipateur thermique (3) de sorte à venir en appui sur la totalité de la surface (8a) de laquelle dépassent les reliefs (7) et s'étendant entre les reliefs (7).

15. Procédé de fabrication d'une carte électronique selon l'une quelconque des revendications 13 à 14, dans lequel l'étape d'assemblage (51) est réalisée au moyen d'une presse comprenant un outillage (42) comprenant une portion (44) configurée et agencée par rapport au dissipateur thermique (3) de sorte à venir en appui sur les reliefs (7) selon la direction z.

16. Procédé de fabrication d'une carte électronique selon l'une quelconque des revendications 12 à 15, dans lequel le circuit imprimé (2) est multicouches et dans lequel l'étape d'assemblage est une étape d'assemblage d'une pluralité de couches du circuit imprimé.

17. Procédé selon l'une quelconque des revendications 12 à 16, dans lequel l'assemblage du dissipateur thermique (3) et du circuit imprimé (2) est réalisé par polymérisation de la colle.

## Patentansprüche

1. Elektronische Karte (1), welche eine Anordnung aus einer Leiterplatte (2) beinhaltet, welche eine erste Seite (4) besitzt, welche mindestens ein elektronisches Bauteil aufnimmt, und aus einem Wärmeableiter (3), wobei die Leiterplatte (2) und der Wärmeableiter (3) entlang einer Stapelrichtung (z) gestapelt sind, wobei der Wärmeableiter (3) an der Leiterplatte an einer zweiten Seite (6) befestigt ist, welche der ersten Seite (4) gegenüber liegt, wobei der Wärmeableiter (3) eine Sohle (8) beinhaltet, welche die Form einer Platte aufweist und Reliefs (7), welche aus einer ebenen Oberfläche (8a) der Sohle (8) herausragen, wobei die Reliefs (7) dazu bestimmt sind, die Kontaktfläche zwischen dem Wärmeableiter (3) und einem Luftstrom zu erhöhen im Vergleich zu der Kontaktfläche zwischen der Sohle (8) und dem Luftstrom, wobei die Sohle (8) zwischen der Leiterplatte (2) und den Reliefs (7) entlang der Stapelrichtung (z) eingefügt ist, **dadurch gekennzeichnet, dass** der Wärmeableiter (3) an der Leiterplatte (2) nur durch Verkleben befestigt ist in der Weise, dass einzig eine Klebeschicht (9) die Sohle (8) und die Leiterplatte (2) trennt, wobei die Klebeschicht einen Klebstoff beinhaltet, welcher sich kontinuierlich von der Sohle (8) bis zur Leiterplatte (2) erstreckt und der Wärmeableiter (3) einstückig ist.

2. Elektronische Karte nach dem vorhergehenden Anspruch, bei welcher die Klebeschicht ein Klebstofffilm ist.

3. Elektronische Karte nach Anspruch 1, bei welcher die Klebeschicht mit Klebstoff imprägnierte Fasern beinhaltet.

4. Elektronische Karte nach einem der vorhergehenden Ansprüche, bei welcher die Klebeschicht ein elektrischer Isolator ist.

5. Elektronische Karte nach einem der vorhergehenden Ansprüche, bei welcher die Klebeschicht wärmehärtbar ist.

6. Elektronische Karte nach einem der vorhergehenden Ansprüche, bei welcher der Wärmeableiter aus Metall ist.

7. Elektronische Karte nach einem der vorhergehenden Ansprüche, bei welcher die Klebeschicht eine Stärke von kleiner als oder gleich 200 µm aufweist.

8. Elektronische Karte nach dem vorhergehenden Anspruch, bei welcher die Klebeschicht eine Stärke zwischen 100 µm und 200 µm aufweist.

9. Elektronische Karte nach einem der vorhergehenden Ansprüche, bei welcher der Wärmeableiter eine Stärke zwischen 5 mm und 20 mm aufweist.

10. Elektronische Karte nach einem der vorhergehenden Ansprüche, bei welcher die Leiterplatte eine Stärke zwischen 0,1 mm und 1 mm aufweist.

11. Elektronische Karte nach einem der vorhergehenden Ansprüche, bei welcher der Wärmeableiter (3) sich im Wesentlichen über die gesamte Nutzfläche der Leiterplatte (2) erstreckt.

12. Herstellungsverfahren einer elektronischen Karte nach einem der vorhergehenden Ansprüche, **dadurch gekennzeichnet, dass** es Folgendes beinhaltet:
- einen Schritt des Stapelns (50), entlang der Stapelrichtung, in welcher man den Wärmeableiter (3) so platziert, dass die Sohle (8) zwischen den Reliefs (7) und der zweiten Seite (6) der Leiterplatte (2) eingefügt ist und in welcher man eine Klebeschicht (9) zwischen der zweiten Seite (6) der Leiterplatte und der Sohle (8) anordnet, wobei die Klebeschicht einen Klebstoff beinhaltet, welcher sich kontinuierlich über die gesamte Stärke des Klebstoffs entlang der Stapelrichtung erstreckt,
- einen Schritt der Montage (51), welcher darin besteht, den Wärmeableiter (3) und die Leiterplatte (2) zu montieren, bei welchem man den erzielten Stapel einem Heißkompressionsvorgang unterwirft.

13. Herstellungsverfahren einer elektronischen Karte nach dem vorhergehenden Anspruch, bei welchem der Schritt des Montierens (51) mit Hilfe einer Presse erfolgt, welche ein Werkzeug (42) beinhaltet, welches einen Abschnitt (44) beinhaltet, welcher in Bezug auf den Wärmeableiter (3) in der Weise konfiguriert und angeordnet ist, dass er an der Oberfläche (8a) anliegt, aus welcher die Reliefs (7) herausragen und sich zwischen die Reliefs (7) erstreckt.

14. Herstellungsverfahren einer elektronischen Karte nach dem vorhergehenden Anspruch, bei welchem der Schritt des Montierens (51) mit Hilfe einer Presse erfolgt, welche ein Werkzeug (42) beinhaltet, welches einen Abschnitt (44) beinhaltet, welcher in Bezug auf den Wärmeableiter (3) in der Weise konfiguriert und angeordnet ist, dass er an der Gesamtheit der Oberfläche (8a) anliegt, aus welcher die Reliefs (7) herausragen und sich zwischen die Reliefs (7) erstreckt.

15. Herstellungsverfahren einer elektronischen Karte nach einem der Ansprüche 13 bis 14, bei welchem der Schritt des Montierens (51) mit Hilfe einer Presse erfolgt, welche ein Werkzeug (42) beinhaltet, welches einen Abschnitt (44) beinhaltet, welcher in Bezug auf den Wärmeableiter (3) in der Weise konfiguriert und angeordnet ist, dass er an den Reliefs (7) entlang der Richtung z anliegt.

16. Herstellungsverfahren einer elektronischen Karte nach einem der Ansprüche 12 bis 15, bei welchem die Leiterplatte (2) aus mehreren Schichten besteht und bei welchem der Schritt des Montierens ein Schritt des Montierens einer Vielzahl von Schichten der Leiterplatte ist.

17. Verfahren nach einem der Ansprüche 12 bis 16, bei welchem die Montage des Wärmeableiters (3) und der Leiterplatte (2) durch Polymerisierung des Klebstoffs erfolgt.

## Claims

1. Electronic circuit board (1) comprising an assembly of a printed circuit board (2) comprising a first face (4) receiving at least one electronic component, and of a heat sink (3), the printed circuit board (2) and the heat sink (3) being stacked in a stacking direction (z), said heat sink (3) being fixed to the printed circuit board on a second face (6) opposite the first face (4), said heat sink (3) comprising a base (8), in the form of a plate, and reliefs (7) extending from a flat surface (8a) of said base (8), the reliefs (7) being intended to increase the contact surface between the heat sink (3) and a flow of air relative to the contact surface between the base (8) and the flow of air, the base (8) being interposed between the printed circuit board (2) and the reliefs (7) in the stacking direction (z), **characterized in that** the heat sink (3) is fixed to the printed circuit board (2) by gluing only such that only an adhesive layer (9) separates the base (8) and the printed circuit board (2), the adhesive layer comprising a glue extending continually from the base (8) to the printed circuit board (2), and **in that** said heat sink (3) is of a single piece.

2. Electronic circuit board according to the preceding claim, in which the adhesive layer is a film of glue.

3. Electronic circuit board according to Claim 1, in which the adhesive layer comprises glue-impregnated fibres.

4. Electronic circuit board according to any one of the preceding claims, in which the adhesive layer is an electrical insulator.

5. Electronic circuit board according to any one of the preceding claims, in which the glue is a thermosetting glue.

6. Electronic circuit board according to any one of the preceding claims, in which the heat sink is made of metal.

7. Electronic circuit board according to any one of the preceding claims, in which the adhesive layer has a thickness of less than or equal to 200 micrometres.

8. Electronic circuit board according to the preceding claim, in which the adhesive layer has a thickness of between 100 micrometres and 200 micrometres.

9. Electronic circuit board according to any one of the preceding claims, in which the heat sink has a thickness of between 5 mm and 20 mm.

10. Electronic circuit board according to any one of the preceding claims, in which the printed circuit board has a thickness of between 0.1 mm and 1 mm.

11. Electronic circuit board according to any one of the preceding claims, in which the heat sink (3) extends substantially over all the useful surface of the printed circuit board (2).

12. Method for manufacturing an electronic circuit board according to any one of the preceding claims, **characterized in that** it comprises:
- a step of stacking (50) in the stacking direction, in which the heat sink (3) is positioned such that the base (8) is interposed between the reliefs (7) and the second face (6) of the printed circuit board (2) and in which an adhesive layer (9) is arranged between the second face (6) of the printed circuit board and the base (8), the adhesive layer comprising a glue extending continually over all the thickness of the glue in the stacking direction,
- an assembly step (51) consisting in assembling the heat sink (3) and the printed circuit board (2) in which the stacking obtained is subjected to a hot compression.

13. Method for manufacturing an electronic circuit board according to the preceding claim, in which the assembly step (51) is performed by means of a press comprising a tool (42) comprising a portion (44) configured and arranged relative to the heat sink (3) so as to come to bear on the surface (8a) from which the reliefs (7) extend and extending between the reliefs (7).

14. Method for manufacturing an electronic circuit board according to the preceding claim, in which the assembly step (51) is performed by means of a press comprising a tool (42) comprising a portion (44) configured and arranged relative to the heat sink (3) so as to come to bear on all of the surface (8a) from which the reliefs (7) extend and extending between the reliefs (7).

15. Method for manufacturing an electronic circuit board according to any one of Claims 13 to 14, in which the assembly step (51) is performed by means of a press comprising a tool (42) comprising a portion (44) configured and arranged relative to the heat sink (3) so as to come to bear on the reliefs (7) in the direction z.

16. Method for manufacturing an electronic circuit board according to any one of Claims 12 to 15, in which the printed circuit board (2) is multilayer and in which the assembly step is a step of assembly of a plurality of layers of the printed circuit board.

17. Method according to any one of Claims 12 to 16, in which the assembly of the heat sink (3) and of the printed circuit board (2) is performed by polymerization of the glue.
